Europäisches Patentamt

(19) European Patent Office    (11) Publication number: **0 128 899**

Office européen des brevets    **B1**

(12)    # EUROPEAN PATENT SPECIFICATION

(45) Date of publication of patent specification: **14.01.87**    (51) Int. Cl.⁴: **H 05 K 13/04**

(21) Application number: **83902031.0**

(22) Date of filing: **11.05.83**

(86) International application number:
**PCT/US83/00719**

(87) International publication number:
**WO 84/02249 07.06.84 Gazette 84/14**

(54) METHOD AND APPARATUS FOR MOUNTING MULTILEAD COMPONENTS ON A CIRCUIT BOARD.

(30) Priority: **02.12.82 US 446142**

(43) Date of publication of application:
**27.12.84 Bulletin 84/52**

(45) Publication of the grant of the patent:
**14.01.87 Bulletin 87/03**

(84) Designated Contracting States:
**BE FR NL SE**

(56) References cited:
**CH-A- 450 508**
**DE-A-2 915 366**
**FR-A-1 367 921**
**US-A-3 508 315**

(73) Proprietor: **Western Electric Company,
Incorporated
222 Broadway
New York, NY 10038 (US)**

(72) Inventor: **HOFFMAN, Brian, David
208 Windsor Court
Somerville, NJ 08876 (US)**
Inventor: **POLLACK, Steven, Howard
300 South Main Street, Apt. No. 804
Yardley, PA 19067 (US)**
Inventor: **WEISSMAN, Barry
166 South Lane
Hightstown, NJ 08520 (US)**

(74) Representative: **Lawrence, Brian Richard et al
Western Electric Company Limited 5,
Mornington Road
Woodford Green Essex IG8 OTU (GB)**

Courier Press, Leamington Spa, England.

## Description

The present invention relates to methods and apparatus for simultaneously mounting one or more multilead components on circuit boards according to the first part of the claims 1 and 4.

When automatically mounting a multilead component on a printed wiring board (PWB), attempts have been made to achieve a high degree of accuracy in the positioning of the leads of a component held by a robotic hand or automatic manipulator with respect to the holes of the PWB. Such control of the robotic hand result in complex and expensive automatic apparatus which has only been able to insert one multilead component at a time into the PWB. Furthermore, the foregoing strict hand positioning requirements do not and cannot compensate for any dimensional deviations existing between the outer housing of the component and its leads.

One such technique is described in U.S. Patent 3,508,315, and CH—A—450—508.

According to the present invention there is provided a method of mounting multilead electrical components on a board comprising the steps of supporting the components proximate the board with each lead of each component proximate to a respective aperture in the board, and inserting the leads into the apertures, characterised in that the components are supported in a releasable template, and in that the board is vibrated, relative to the components in order to ensure that the leads are inserted into the respective apertures upon opening of the template and release of the components therefrom.

Also according to the invention, an apparatus as defined in claim 4 is provided.

The vibration of the circuit board can be effected before or after release of the component by the template, and is preferably in directions substantially parallel to its plane thereby causing each lead of the multilead electrical component to be inserted in its corresponding aperture in the PWB.

One advantage of the embodiments are the ability to automatically mount a plurality of multilead components on boards regardless of reasonable dimensional deviations in the position of the outer housing of the components relative to their leads.

Another advantage is the ability to simultaneously mount several types of multilead components having diverse geometries on the same board without requiring operator assistance.

A further advantage is that a single programmable robotic arm can be employed and that robotic arm movements are minimized.

Brief Description of the Drawings
FIG. 1 is a perspective view of an embodiment apparatus;
FIG. 2 is a perspective view of an alternative embodiment apparatus;
FIG. 3 illustrates an embodiment template; and

FIG. 4 is a cross-sectional view along line 4—4 of FIG. 3.

Each circuit board 20 with apertures 21 in various patterns, e.g. 24, is mounted in turn on a base 22 by mounting bodies 23. A plurality of multilead components of various shapes 25, 26, 27, 28 are to be mounted on board 20 with the leads of each component to be inserted in a respective aperture pattern. Each board 20 is also coupled to the base 22 by a mechanism 29 capable of imparting a vibratory motion of controlled frequency and amplitude to the board. One way of accomplishing this is to use compliant mounting bodies 23 such as spring mounted legs. Alternatively, mounting bodies 23 may include suspension springs between the base and the board.

Such vibratory motion, which is preferably in the plane of the board 20, may be accomplished, for example, by means of a motor 30 having an eccentrically mounted shaft 31 attached to the board. However, other types of vibrating mechanisms, as well as vibratory motions in a direction substantially perpendicular to the plane of the board may be used.

In order to simultaneously mount the components 25 to 28 on the board 20, they are all initially held proximate to the surface of board 20. Next, these components 25 to 28 are simultaneously placed on the surface of the board 20 such that each component has its leads proximate to a corresponding aperture 21 in the board. The components 25 to 28 prior to placing them on the board 20 are loaded either manually or automatically into a releasable three-part closed template 32 which, when closed, has substantially matching openings 34 to 37 adapted to receive the outer bodies of components 25 to 28, respectively. The dimensions of the openings are selected to substantially match the outer dimensions of the components to be mounted. Also, each opening 34 to 37 is located in template 32 to substantially match the position and orientation of its corresponding component aperture pattern 24. Furthermore, each opening may comprise a pair of retaining protrusions or lips 33 for holding a component when the template is closed. Template 32 comprises a central portion 38 releasably coupled to two outer portions 39 and 40 along edges 41 and 42.

The loaded template 32 is positioned proximate to the vibrating board 20 in a direction substantially parallel thereto by means of a programmable manipulator 43, e.g. a robotic arm, operated by a computer control terminal 44. The manipulator 43 such as PUMA Model 560 is capable of lifting and locating the template and components via wrist 45 with sufficient accuracy proximate that each component is positioned near its corresponding location on the board.

The template portions 38, 39 and 40 are then separated from each other by laterally displacing portions 39 and 40 away from the central portion 38, as schematically shown by the directional arrows on the template portions 39 and 40. The closing and opening of the template is performed by the manipulator under the control of terminal 44. This results in the enlargement of openings 34 to 37, and in a simultaneous release from lips 33 of the components 25 to 28 out of their respective enlarged openings 34 to 37 onto the surface of the vibrating board 20. The releasable template 32 is maintained in its parallel position proximate to the board 20 for a delay period. During a portion of such delay period, each component which is placed on the surface of the board 20 is confined within its corresponding opening in the template 32 and this ensures that the leads of the components will be inserted in their respective apertures in the board. In other words, the template openings prevent each component from moving away from its corresponding aperture pattern on the vibrating board. At the end of the delay period, which may be fixed or variable in response to sensing means, the template is withdrawn above the highest component inserted on the board, and is thus ready for a new loading cycle on a new empty board.

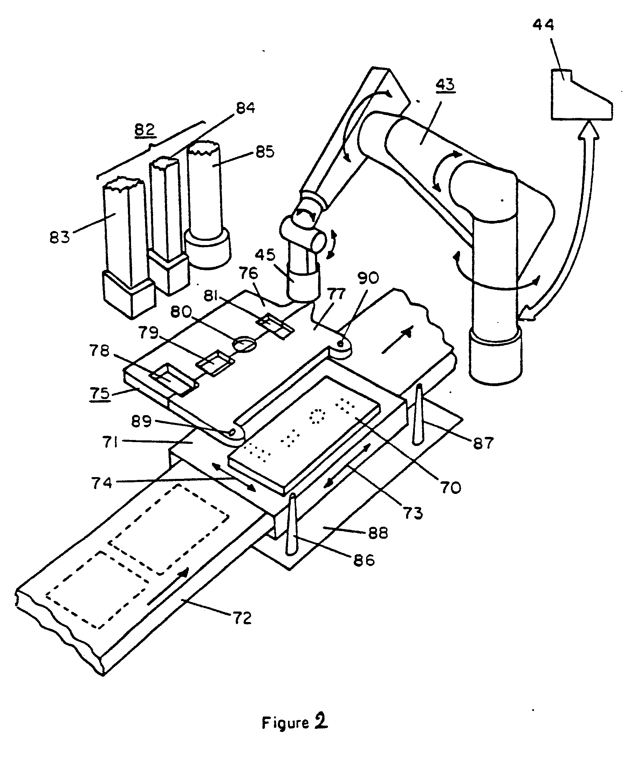

In the embodiment shown in FIG. 2 the circuit board 70 is transported to a work station 71 by means of a conveyor 72. Work station 71 is capable of vibrating in directions 73 and/or 74. The board 70 is temporarily secured to the vibratory work station 71. A releasable template 75 cmprising two coplanar portions 76 and 77 has a plurality of openings 78, 79, 80 and 81 adapted to receive a corresponding plurality of components (not shown) to be mounted on board 70, and is held at the wrist 45. A components feeding arrangement 82 comprises a plurality of differently shaped feeding tubes 83, 84 and 85, each acting as a source for delivering the multilead components one at a time at a preselected speed or rate.

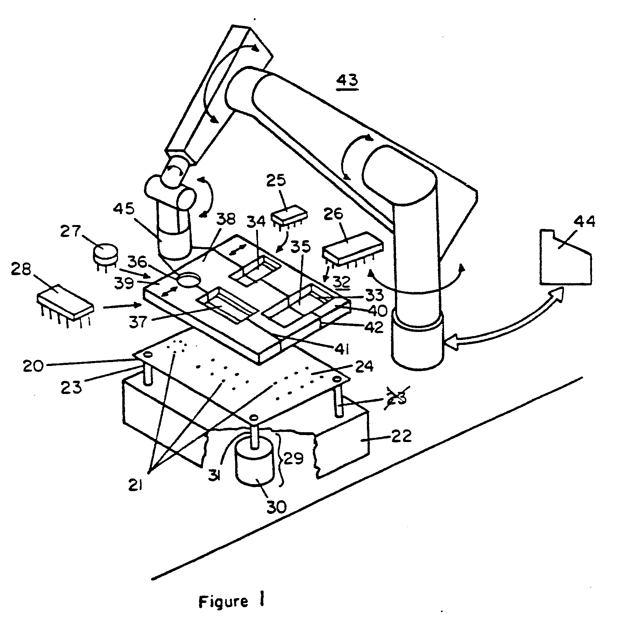

The template 75 is loaded by sequentially locating each opening underneath a respective feeding tube and by transferring components out of tubes into respective openings whilst template portions 76 and 77 are held together. Each component is held within the opening by a pair of retaining protrusions or lips. The components-loaded-template 75 is positioned in substantially parallel spaced relation to the board 70 at predetermined coordinate positions with respect thereto, and the components are simultaneously released out of their respective openings 78 to 81 of the template onto the board. In order to release the components out of the template 75, portions 76 and 77 are "separated" to provide enlarged openings to release the components to enable the leads of the components to enter into respective apertures in the vibrating board in a similar manner to the Fig. 1 embodiment.

The positioning of the template 75 by means of the programmable robotic arm 43 may be substantially aided by using a set of auxiliary locating devices, e.g. tapered pins 86 and 87, attached to a non-vibrating portion 88 of the work station 71 and adapted to be inserted in mating apertures 89 and 90 of one portion (e.g. 77) of the releasable template 75.

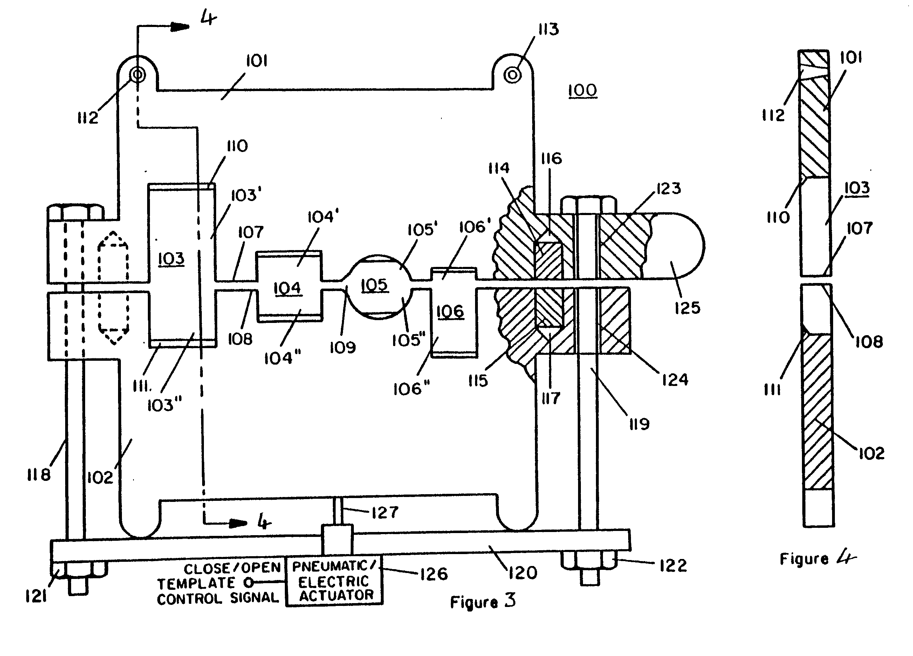

FIG. 3 illustratively shows a releasable template 100 with two coplanar portions 101 and 102 in the "open" or released position. Templates having a greater number of portions are possible. As shown in FIG. 3, portion 101 has a plurality of indentations 103', 104', 105' and 106' along an edge 107 thereof. Similarly, portion 102 has a plurality of indentations 103'', 104'', 105'' and 106'' along an edge 108. The two portions 101 and 102 are positioned with respect to each other to form a plurality of resulting openings 103, 104, 105 and 106 comprising combinations of indentations. Opening 105 comprises a reference notch 109 to enable a proper positioning of a circular component within the template by aligning the notch with a corresponding reference key located on the housing of the component.

The overall dimensions of these opening 103 to · 106 in their "closed" position are selected to be somewhat larger than the dimensions of the outer bodies of the components to be mounted. Each opening, comprises a pair of retaining protrusions or lips 110 and 111, (Fig. 4) adapted to hold a corresponding component within such opening.

In order to facilitate the positioning of the template 100 with respect to a board, the template comprises a pair of locating apertures 112 and 113 to match those of locating pins 86 and 87 (FIG. 2).

One arrangement for coupling template portion 101 to template portion 102 may comprise two pairs of permanent magnets of which only one pair of magnets 114 and 115, embedded in respective cavities 116 and 117 is shown. The magnets of each pair are poled to repel each other, and cause the edges 107 and 108 to normally separate from each other resulting in the somewhat enlarged openings 103 and 106 (FIG. 3) when the template is in its "open" position. Alternative means for generating a repulsion force between portions 101 and 102 may be used, e.g. a spring arrangement or dual acting air cylinders inserted in cavities 116 and 117.

The coupling arrangement further comprises a pair of fastening bolts 118 and 119 attached to a coupling bar 120 by nuts 121, 122, and slidably engaged in passages 123 and/or 124 with at least one template portion 101 and 102 to permit their coplanar relative movement. Since the coupling bar 120 is held against the template portion 102, the tightening or loosening of the nuts 121 and 122 will control the dimensions of the openings 103 to 106 when the releasable template is in its "open" or released position. The releasable template 100 may be held from a portion 125 coupled to wrist 45. The releasable template may alternatively be held from another part provided that portions 101 and 102 are not simultaneously held by the robotic arm.

Template 100 is closed by coupling an actuator 126 to the bar 120 such that a displacement output cylinder 127 of the actuator is positioned against the template portion 102. Actuator 126 may be an electrical solenoid, an air cylinder, or any other device capable of displacing a cylinder or small shaft in response to a control signal. The template close/open control signal corresponds to the close/open hand or grippers signal usually available on programmable robotic arms. The close template control signal causes the actuator 126 to close the template. In this embodiment, template portion 102 is the only part of the template coupling arrangement capable of moving in response to the force exerted by cylinder 127. Removal of the control signal retracts cylinder 127 and returns template portion 102 to the open position.

The protrusions or lips 110 and 111 retain components in the same manner as lips 33 (FIG. 1).

The above could apply to releasable templates comprising more than two coplanar template portions. In the FIG. 1 embodiment the coupling between portion 38 and portions 39 and 40 may be achieved by pairs of repelling permanent magnets, in a similar manner to magnets of FIG. 3. Thus, due to the presence of these repelling magnets, a gap is formed on each side of the central portion 38 along its edges 41 and 42. Furthermore, a pair of fastening bolts, a coupling bar and a selectively energizable actuator of the type described above, would enable the "opening" and "closing" of the three-portion releasable template 32.

## Claims

1. A method of mounting multilead electrical components (25) on a board (20) comprising the steps of supporting the components proximate the board with each lead (11) of each component proximate to a respective aperture (21) in the board, and inserting the leads into the apertures, characterised in that the components are supported in a releasable template (32), and in that the board is vibrated (via 29) relative to the components in order to ensure that the leads are inserted into the respective apertures upon opening of the template and release of the components therefrom.

2. A method according to claim 1, in which the components are loaded at a loading position (adjacent 82) into respective openings (34—37) in the template, characterised in that the loading step is performed with the template in the closed condition.

3. A method according to claim 2, characterised in that the template is moved from the loading position to a releasing position and then released by programmable manipulation.

4. Apparatus for automatically mounting multilead components (25) on a board (20) said apparatus comprising a board supporting arrangement (22), a support having a plurality of openings (34—37) each substantially matching a respective component (25—28) to be supported therein, an arrangement for loading the components into the said openings, means for positioning the loaded support at a preselected position with respect to the board, and means for inserting the leads of each component into respective apertures of the board, characterised in that the said support is a releasable template openable to release components to be supported thereby, and in that vibration means 29 is provided to vibrate the board relative to the components to ensure that the leads of released components are inserted into the respective apertures.

5. Apparatus according to claim 4, characterised in that a programmable robotic arrangement (43, 44) is provided for positioning and releasing the template.

6. Apparatus according to claim 4 or 5, characterised in that the releasable template comprises a plurality of coplanar portions (38, 39, 40), each portion being repelled from its adjacent portion by repulsion means (114, 115).

7. Apparatus according to claim 6, characterised in that the repulsion means are magnetic bodies embedded in the said coplanar portions and poled to repel each other.

8. Apparatus according to claim 4, 5, 6 or 7, characterised by a coupling bar (120) coupled to actuating means (126) for controlling the movement of the said coplanar portions against the action of the repulsion means.

9. Apparatus according to any one of claims 4 to 8, characterised in that each opening in the template is provided with lips (33) for retaining a component within the opening when the template is in its closed condition, the lips being dimensioned to release the component out of the template opening when the template is in its open condition.

## Patentansprüche

1. Verfahren zum Befestigen von Unterteilen (25 bis 28) mit mehreren Anschlußdrähten auf gedruckten Schaltungen (20, 70) mit folgenden Maßnahmen: die Unterteile werden nahe der gedruckten Schaltung mit den jeweiligen Anschlußdrähten (11) jedes Unterteils benachbart einer jeweiligen Öffnung (21) in der Schaltung gehalten, und die Anschlußdrähte werden in die Öffnungen eingefügt,
dadurch gekennzeichnet, daß die Unterteile in einer lösbaren Führungslehre (32, 75, 100) gehalten werden und daß die gedruckte Schaltung gegenüber den Unterteilen vibriert wird (über 29), um sicherzustellen, daß die Anschlußdrähte in die jeweiligen Öffnungen beim Öffnen der Führungslehre eingeführt werden und die Unterteile von der Führungslehre losgelassen werden.

2. Verfahren nach Anspruch 1, bei welchem die Unterteile in eine Ladeposition (benachbart 82) in jeweilige Öffnungen (34 bis 37; 78 bis 81; 103 bis 106) in der Führungslehre eingebracht werden, dadurch gekennzeichnet, daß der Ladeschritt mit der Führungslehre in geschlossener Lage ausgeführt wird.

3. Verfahren nach Anspruch 2, dadurch gekennzeichnet, daß die Führungslehre von der Ladeposition zu einer Loslaßposition bewegt wird, wo dann durch programmierbare Betätigung losgelassen wird.

4. Vorrichtung zum automatischen Befestigen von Unterteile (25 bis 28) mit mehreren Anschlußdrähten auf gedruckten Schaltungen (20; 70) mit einer Anordnung (22) zur Stützung der gedruckten Schaltung, einem Träger mit einer Mehrzahl von Öffnungen (34 bis 37; 78 bis 81; 103 bis 106), die jeweils zur Abstützung eines jeweiligen Unterteils (25 bis 28) im großen und ganzen passen, einer Anordnung (82) zum Laden der Bauteile in die Öffnungen, einer Einrichtung (43) zur Positionierung des beladenen Trägers an vorgewählter Stelle mit Bezug auf die gedruckte Schaltung und einer Einrichtung zum Einfügen der Anschlußdrähte jedes Unterteils in entsprechende Öffnungen der gedruckten Schaltung, dadurch gekennzeichnet, daß der Träger eine lösbare Führungslehre (32, 75, 100) ist, die zum Loslassen der darin zu haltenden Unterteile zu öffnen ist, und daß eine Vibrationseinrichtung (29) zum Schütteln der gedruckten Schaltung relativ zu den Unterteilen vorgesehen ist, um sicherzustellen, daß die Anschlußdrähte von losgelassenen Unterteilen in die jeweiligen Öffnungen eingefügt werden.

5. Vorrichtung nach Anspruch 4, dadurch gekennzeichnet, daß eine programmierbare Roboteranordnung (43, 44) zur Positionierung und zum Loslassen der Führungslehre vorgesehen ist.

6. Vorrichtung nach Anspruch 4 oder 5, dadurch gekennzeichnet, daß die lösbare Führungslehre eine Mehrzahl von in einer gemeinsamen Ebene angeordneten Teilen (38, 39, 40; 76, 77; 101, 102) aufweist und daß jedes Teil vom benachbarten Teil durch Abstoßmittel (114, 115) rückgestoßen wird.

7. Vorrichtung nach Anspruch 6, dadurch gekennzeichnet, daß die Abstoßeinrichtungen magnetische Körper sind, die in den in einer Ebene angeordneten Teilen eingebettet sind und so gepolt sind, daß sie einander abstoßen.

8. Vorrichtung nach Anspruch 4, 5, 6 oder 7, dadurch gekennzeichnet, daß eine Koppelstange (120) mit einer Betätigungseinrichtung (126) verbunden ist, um die Bewegung der in gleicher Ebene angeordneten Teile gegen die Wirkung der Abstoßeinrichtungen zu steuern.

9. Vorrichtung nach einem der Ansprüche 4 bis 8, dadurch gekennzeichnet, daß jede Öffnung in der Führungslehre mit Lippen (33; 110, 111) zum Halten eines Unterteils innerhalb der Öffnung versehen ist, wenn die Führungslehre in ihrer geschlossenen Lage ist und daß die Lippen so dimensioniert sind, daß die Unterteile aus der jeweiligen Öffnung der Führungslehre losgelassen werden, wenn die Führungslehre in ihrer offenen Lage ist.

**Revendications**

1. Un procédé de montage de composants électriques multi-conducteurs (25) sur une carte (20), comprenant les opérations qui consistent à supporter les composants à proximité de la carte, avec chaque conducteur (11) de chaque composant situé à proximité d'un trou respectif (21) dans la carte, et à introduire les conducteurs dans les trous, caractérisé en ce qu'on supporte les composants dans un gabarit ouvrant (32), et en ce qu'on fait vibrer la carte (par l'élément 29) par rapport aux composants, pour faire en sorte que les conducteurs soient insérés dans les trous respectifs au moment de l'ouverture du gabarit et de la libération des composants qu'il contient.

2. Un procédé selon la revendication 1, dans lequel on charge les composants dans des ouvertures respectives (34—37) dans le gabarit, à une position de chargement (adjacente à l'élément 82), caractérisé en ce qu'on accomplit l'opération de chargement avec le gabarit à l'état fermé.

3. Un procédé selon la revendication 2, caractérisé en ce qu'on déplace le gabarit de la position de chargement vers une position d'ouverture et on l'ouvre ensuite, par manipulation programmable.

4. Dispositif destiné au montage automatique de composants multi-conducteurs (25) sur une carte (20), ce dispositif comprenant une structure de support de carte (22), un support comportant un ensemble d'ouvertures (34—37), chacune d'elles correspondant pratiquement à un composant respectif (25—28) devant être supporté à l'intérieur, une structure destinée à charger les composants dans les ouvertures, des moyens destinés à positionner le support chargé à une position présélectionnée par rapport à la carte, et des moyens destinés à insérer les conducteurs de chaque composant dans des trous respectifs de la carte, caractérisé en ce que le support consiste en un gabarit ouvrant qu'on peut ouvrir pour libérer les composants qu'il supporte, et en ce que des moyens de vibration (29) sont prévus pour faire vibrer la carte par rapport aux composants, pour faire en sorte que les conducteurs de composants libérés soient introduits dans les ouvertures respectives.

5. Dispositif selon la revendication 4, caractérisé en ce qu'il comporte une structure de robot programmable (43, 44) pour positionner et ouvrir le gabarit.

6. Dispositif selon la revendication 4 ou 5, caractérisé en ce que le gabarit ouvrant comprend un ensemble de parties coplanaires (38, 39, 40), et des moyens de répulsion (114, 115) repoussent chaque partie par rapport à la partie adjacente.

7. Dispositif selon la revendication 6, caractérisé en ce que les moyens de répulsion sont des éléments magnétiques encastrés dans les parties coplanaires et dont les pôles sont disposés de façon à produire une répulsion mutuelle.

8. Dispositif selon la revendication 4, 5, 6 ou 7, caractérisé par une barre d'accouplement (120) qui est accouplée à des moyens d'actionnement (126) pour commander le mouvement des parties coplanaires contre l'action des moyens de répulsion.

9. Dispositif selon l'une quelconque des revendications 4 à 8, caractérisé en ce que chaque ouverture formée dans le gabarit comporte des lèvres (33) destinées à retenir un composant à l'intérieur de l'ouverture lorsque le gabarit est dans son état fermé, et ces lèvres sont dimensionnées de façon à libérer le composant par rapport à l'ouverture du gabarit lorsque ce dernier est dans son état ouvert.

Figure 1

Figure 2

CLOSE/OPEN
TEMPLATE O
CONTROL SIGNAL

PNEUMATIC/
ELECTRIC
ACTUATOR

Figure 3

Figure 4

0 128 899

3